(19) Europäisches Patentamt
European Patent Office
Office européen des brevets

(11) **EP 3 375 270 B1**

(12) **EUROPÄISCHE PATENTSCHRIFT**

(45) Veröffentlichungstag und Bekanntmachung des Hinweises auf die Patenterteilung:
**05.01.2022 Patentblatt 2022/01**

(21) Anmeldenummer: **16709408.5**

(22) Anmeldetag: **10.03.2016**

(51) Int Cl.:
***H05K 13/08*** *(2006.01)*

(86) Internationale Anmeldenummer:
**PCT/EP2016/055138**

(87) Internationale Veröffentlichungsnummer:
**WO 2017/152979 (14.09.2017 Gazette 2017/37)**

(54) **COMPUTERGESTÜTZTES VERFAHREN UND VORRICHTUNG ZUR ZUORDNUNG VON BAUGRUPPEN AUF BESTÜCKUNGSLINIEN**

COMPUTER IMPLEMENTED METHOD AND DEVICE FOR ALLOCATING ASSEMBLIES TO PLACEMENT LINES

PROCÉDÉ ASSISTÉE PAR ORDINATEUR ET DISPOSITIF D'ATTRIBUTION DE MODULES À DES LIGNES DE PLACEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**19.09.2018 Patentblatt 2018/38**

(73) Patentinhaber: **Siemens Aktiengesellschaft 80333 München (DE)**

(72) Erfinder:
- **PFAFFINGER, Alexander
  81739 München (DE)**
- **ROYER, Christian
  85521 Ottobrunn (DE)**

(56) Entgegenhaltungen:
**EP-A1- 2 894 528        DE-A1-102008 020 167
DE-A1-102011 076 565    DE-B4-102011 076 565**

**Beschreibung**

Die vorliegende Erfindung betrifft ein computergestütztes Verfahren zur Zuordnung von Baugruppen auf Bestückungslinien zur Bestückung der Baugruppen mit Bauelementen. Weiterhin betrifft die Erfindung eine Vorrichtung für eine Fertigungs- oder Montagelinie zur Bestückung von Baugruppen mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Ein Hersteller von SMT- Bestückungsautomaten und -systeme mit dem Produktnamen SIPLACE ist beispielsweise die Firma ASM (http://www.siplace.com/en/Home).

Auf Grund von technischen Restriktionen kann aber nicht jede Baugruppe auf jeder Bestückungslinie gefertigt werden. Die Baugruppen besitzen auf den Bestückungslinien meist auch unterschiedliche Produktionszeiten. Zudem dürfen die maximalen Produktionszeitkapazitäten der Bestückungslinien nicht überschritten werden.

Die Zuordnung von Baugruppen auf Bestückungslinien eines Bestückungssystems erfolgt üblicherweise manuell oder halbautomatisch, basierend auf Erfahrungswerten oder Heuristiken.

Aus DE 10 2008 020 167 A1 ist ein Verfahren zum Bestimmen einer optimalen Zuordnung von einem zu fertigenden Produkt zu einer ausgewählten Produktionslinie von einer Mehrzahl von unterschiedlich konfigurierten Produktionslinien beschrieben.

Das Verfahren weist auf (a) ein Berechnen der jeweiligen Produktionsdauern für das Produkt für jede Produktionslinie, und (b) ein Auswählen der ausgewählten Produktionslinie, basierend auf den berechneten Produktionsdauern. Dabei werden die jeweiligen Produktionsdauern unter Verwendung eines Ablaufgenerators berechnet, bei dem mehrere für die Fertigung des Produkts erforderliche Handhabungsschritte der jeweiligen Produktionslinie in eine geeignete zeitliche Abfolge gesetzt werden.

Aus EP 284 528 A1 ist ein Produktionslinienmanagementsystem bekannt. Es registriert und verwaltet in einheitlicher Weise Verteilungsdaten für jede Produktionsline. Es ermöglicht die Handhabung von einer kleinen Menge von Daten mit Hilfe eines Identifiers, der den Daten zugefügt wird, und vereinfacht die Systemkonfiguration.

Da der Planungshorizont in der Fertigung meist mittelfristig ist, gibt es Unsicherheiten hinsichtlich der zukünftigen Stückzahlen der unterschiedlichen Baugruppentypen. Dies kann zu unerwünscht starken Schwankungen der Auslastungen/Produktionszeiten der Bestückungslinien führen. Deshalb ist es in der Praxis erwünscht, Baugruppen-Linien-Zuordnungen zu vermeiden, mit denen bei einzelnen Linien besonders hohe Produktionszeitschwankungen auftreten können. Dies kann zur Folge haben, dass die entsprechenden Linien oft überlastet oder unterlastet sind.

Bei einem möglichen Einsatz von mathematischen Optimierungsmethoden sind lineare Optimierungsmethoden bzw. -verfahren möglich. Die lineare Optimierung befasst sich mit der Optimierung linearer Zielfunktionen über einer Menge, die durch lineare Gleichungen und Ungleichungen eingeschränkt ist. Sie ist Grundlage der Lösungsverfahren der (gemischt-) ganzzahligen linearen Optimierung. Ein sogenannter Solver (*Löser*) ist eine Sammelbezeichnung für spezielle mathematische Computerprogramme, die mathematische Probleme numerisch lösen können. Im Zusammenhang mit MIP (mixed integer linear programming bzw. gemischt ganzzahlige Lineare Programmierung) können für kleine IP-Programme (ganzzahlige Optimierungsmodelle) Standardsolver wie z.B. CPLEX, Gurobi verwendet werden. Als kleine IP-Programme sind beispielsweise Instanzen mit 2 Linien, 181 Baugruppen und 839 Bauelementtypen denkbar. Bei größeren Instanzen können mit Standardsolvern wie CPLEX Probleme auftreten, diese komplexere Problemstellung zu lösen.

US 6,829,514 B2 schlägt vor, in einer Fertigung für elektronische Baugruppen für die Optimierung einzelner Fertigungslinien Gemischt Ganzzahlige Lineare Programmierung einzusetzen.

DE 198 34 620 A1 betrifft ein Verfahren zur Ermittlung einer Aufrüstung für einen Mix unterschiedlicher Baugruppentypen in einer Bestückungslinie.

Aus DE 10 2011 076 565 B4, WO2014/005741 A1, WO2014/005743 A1, WO2014/005744 A1 sind Methoden bekannt, welche Beispiele für Optimierungsmethoden mittels MIP für Zuordnungen von Baugruppen auf Bestückungslinien sind.

Vor allem aus DE 10 2011 076 565 B4 ist ein Verfahren zur Zuordnung von Leiterplatten auf Bestücklinien zur Bestückung der Leiterplatten mit Bauelementen bekannt, womit eine möglichst geringe Bauelementvarianz und eine möglichst optimale Produktionszeit unter vorgegebenen Randbedingungen erreicht wird. Dabei ist die Bauelementvarianz bestimmt als Summe der Anzahlen der auf den Bestücklinien benötigten Bauelementtypen.

Eine Rüstfamilie ist bestimmt als eine Menge von Baugruppen, die auf einer Bestückungslinie bestückt werden können, ohne die Menge der Bauelementetypen zu ändern, die an der Bestückungslinie für die Bestückung bereit gehalten sind. Die Menge der an der Bestückungslinie bereit gehaltenen Bauelementetypen wird auch Rüstung genannt. Üblicherweise sind einer Bestückungslinie mehr Baugruppen zugeordnet als von einer Rüstfamilie umfasst sein können, da an der Bestückungslinie nicht beliebig viele Bauelementetypen bereit gehalten werden können. Die Bestückungslinie wird daher gelegentlich einem Rüstwechsel unterzogen, bei dem die Rüstung für eine erste Rüstfamilie gegen die Rüstung für eine zweite Rüstfamilie gewechselt wird. Je seltener diese Rüstwechsel sind, desto weniger zeitaufwendig kann das Bestückungssystem betrieben werden. Die Anzahl der insgesamt im Bestückungssystem verwendeten Rüstfamilien kann einen realistischeren Qualitätsindikator als beispielsweise die Bauelementvarianz einer Bestückungsline darstellen. Die Bauelementvarianz einer Bestückungslinie ist dabei durch die Anzahl unterschiedlicher Bauelementetypen gegeben, deren Bauelemente auf eine der Baugruppen zu bestücken sind, die der Bestückungslinie zugeordnet sind. Das aus DE 10 2011 076 565 B4 bekannte Verfahren kann daher Zuordnungen von Baugruppen an Bestückungslinien bestimmen, die eine verbesserte Auslastung des gesamten Bestückungssystems erlauben.

Um maximale Produktionszeitschwankungen der einzelnen Linien zu beschränken oder diese so weit wie möglich zu minimieren, sind weitere Verbesserungen im IP-Modell notwendig.

Um Lösungen für größere Instanzen bzw. komplexere Problemstellungen überhaupt oder sogar optimiert erzielen zu können, ist eine gute bzw. genaue Auswahl an Parametern im IP-Modell bzw. IP-Programm mit den anzuwendenden Restriktionen bzw. den benutzerdefinierten Vorgaben wesentlich.

Es ist Aufgabe der vorliegenden Erfindung, eine gegenüber dem genannten Stand der Technik eine verbesserte Optimierungsmethode bzw. -technik zur Zuordnung von Baugruppen auf Bestückungslinien bereitzustellen.

Diese Aufgabe wird durch die unabhängigen Ansprüche gelöst.

Vorteilhafte Weiterbildungen sind Gegenstand der abhängigen Ansprüche.

Die Erfindung beansprucht ein computergestütztes Verfahren zur Zuordnung von Baugruppen (LP1 - LP6) auf Bestückungslinien (BL1 - BL6) zur Bestückung der Baugruppen (LP1 - LP6) mit Bauelementen (B1 - B6), um eine minimale Bauelementvarianz bei vorgegebenen maximalen zeitlichen Auslastungen pro Bestückungslinie (BL1 - BL2) zu erreichen, wobei die Bauelementvarianz bestimmt wird als Summe der Anzahlen der auf den Bestückungslinien (BL1 - BL2) benötigten Bauelementtypen, wobei für jeden Baugruppentyp der zu bestückenden Baugruppen (LP1 - LP6) und jede Bestückungslinie (BL1 - BL2) unter Berücksichtigung der jeweiligen Taktzeit des Baugruppentyps auf der Bestückungslinie (BL1 - BL2), den jeweiligen Umrüstzeiten, dem jeweiligen Liniennutzungsgrad und der pro Baugruppentyp erwarteten zu produzierenden Stückzahl eine erwartete Produktionszeit ermittelt wird,

wobei die tatsächliche zu produzierende Stückzahl gemäß einer vorher bestimmbaren Wahrscheinlichkeitsverteilung auftritt, wobei für die einer Linie (BL1 - BL2) zugeordneten Menge von Baugruppen (LP1 - LP6) die Summe dieser erwarteten (Gesamt-) Produktionszeiten die maximale zeitliche Auslastung der jeweiligen Bestückungslinie (BL1 - BL2) nicht überschreiten darf, wobei die möglichen Zuordnungen von Baugruppen (LP1 - LP6) auf die Bestückungslinien (BL1 - BL2) durch die vorhandene Infrastruktur oder durch benutzerdefinierte Vorgaben eingeschränkt sind, wobei die Zuordnung derart erfolgt, dass für die aus den genannten Wahrscheinlichkeitsverteilungen für die Stückzahlen resultierenden Wahrscheinlichkeitsverteilungen für die Summe der erwarteten Produktionszeiten pro Bestückungslinie die Abweichungen vom jeweiligen Erwartungswert dieser resultierenden Wahrscheinlichkeitsverteilungen durch einen vorgebbaren maximalen Schwellwert begrenzt sind, wobei

eine Abweichung von der Summe der erwarteten Produktionszeiten einer Bestückungslinie als Varianz derselben bezeichnet wird, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann,

und

wobei die Zuordnung der Baugruppen (LP1 - LP6) auf die Bestückungslinien (BL1 - BL1) unter den gegebenen Vorgaben mittels ganzzahliger Linearen Programmierung berechnet wird, wobei eine gewichtete Summe bestehend aus der Bauelementvarianz und aus der maximalen Abweichung von der Summe der erwarteten Produktionszeiten minimiert wird.

Eine Ausführungsform der Erfindung ist die Minimierung der Summe der Abweichungen vom jeweiligen Erwartungswert.

Der Vorteil des erfindungsgemäßen Vorgehens liegt darin, dass nun auch Problemstellungen mit größeren Instanzen weniger rechenintensiv als mit heuristischen Vorgehensweisen gelöst werden können.

Als Optimierungsmethode kann die sogenannte ganzzahlige Lineare Programmierung angewendet werden. Dadurch können kommerzielle Standardsolver eingesetzt werden. Die genannten Abweichungen von den Erwartungswerten der resultierenden Wahrscheinlichkeitsverteilungen kann ähnliche oder gleiche Werte annehmen. Ähnlich kann hierbei bedeuten, dass eine maximale Abweichung nach oben oder unten zugelassen wird. "Gleich" kann hierbei identisch bedeuten. Es sind jedoch bei (nahezu) gleichen Werten auch geringe Ungenauigkeiten in Form von geringfügigen Abweichungen nach oben oder unten möglich, wobei im Gegensatz zu "ähnlich" solch eine geringfügige Abweichung kaum planbar und somit kaum vorbestimmbar ist.

Es kann sinnvoll sein, wenn vom Benutzer vorgegebene Mengen von Baugruppen auf dieselbe Bestückungslinie zugeordnet werden.

Die Varianz pro Bestückungslinie kann bestimmt werden durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit.

Als Eingabedaten für die ganzzahlige Lineare Programmierung können folgende, die Infrastruktur beschreibende Daten verwendet werden:

- Anzahl der Bestückungslinien,
- Anzahl der Baugruppen,
- Anzahl der Baugruppentypen,
- Anzahl der Bauelementtypen,Menge der zu bestückenden Bauelementtypen pro Baugruppentyp,
- Produktionszeitschranke pro jeweiliger Bestückungslinie,
- Wahrscheinlichkeitsverteilungen für die erwarteten Stückzahlen der Baugruppentypen.

Die Gesamtproduktionszeit für einen jeweiligen Baugruppentyp auf einer jeweiligen Bestückungslinie kann berechnet werden aus:

- die erwarteten Stückzahlen,
- der Anzahl der zu erwartenden Aufträge,
- der Losgrößen,
- der Umrüstzeiten,
- der Einzelproduktionszeiten pro Baugruppe und Bestückungslinie,
- minimale Taktzeiten der Bestückungslinien,
- Nutzungsgrade der Bestückungslinien.

Die Lineare Programmierung kann mittels eines ganzzahligen Linearen Programms eingestellt werden, das durch folgende Schritte gelöst wird:

a) Ermitteln einer ersten aktuellen Lösung, die eine Zuordnung von Baugruppen auf Produktionslinien repräsentiert,
b) Zuordnen von einer ausgewählten Menge von Baugruppen auf die Bestückungslinien, basierend auf einer aktuellen Lösung,
c) Berechnen der neuen Zuordnungen mittels eines Optimierungsprogrammes oder eines Standardsolvers basierend auf ganzzahliger linearer Programmierung.

Die oben beschriebenen Schritte können iterativ durchgeführt werden und ein Programmabbruch erfolgt, wenn eine vorher festgelegte Zeitgrenze oder Lösungsgüte erreicht worden ist.
Während das beanspruchte Verfahren eine erste Zielfunktion der Optimierungsmethode definiert, kann das beanspruchte Verfahren zusätzlich mit einer zweite Zielfunktion ergänzt werden, die zum möglichst besten Ergebnis bezüglich der Abweichungen vom jeweiligen Erwartungswert hin konvergieren soll. Die erste Zielfunktion ist die Bauelementvarianz.
Der Benutzer kann manuell vorgeben, ob bei der Gesamtoptimierung mit beiden Zielfunktionen mehr Gewicht auf die erste Zielfunktion oder mehr Gewicht auf die zweite Zielfunktion gelegt werden soll.
Ein weiterer Aspekt der Erfindung sieht eine Vorrichtung zur Zuordnung von Baugruppen auf Bestückungslinien zur Bestückung der Baugruppen mit Bauelementen, aufweisend:

- eine Einheit zum Ermitteln einer erwarteten Produktionszeit für jeden Baugruppentyp der zu bestückenden Baugruppen und für jede Bestückungslinie unter Berücksichtigung der jeweiligen Taktzeit des Baugruppentyps auf der Bestückungslinie und der pro Baugruppentyp erwarteten zu produzierenden Stückzahl, wobei die tatsächliche zu produzierende Stückzahl gemäß einer vorher bestimmbaren Wahrscheinlichkeitsverteilung auftreten kann, wobei für die einer Linie zugeordneten Menge von Baugruppen die Summe dieser erwarteten (Gesamt-)Produktionszeiten die maximale zeitliche Auslastung der jeweiligen Bestückungslinie nicht überschreiten darf, wobei die möglichen Zuordnungen von Baugruppen auf Bestückungslinien durch die vorhandene Infrastruktur und/oder durch benutzerdefinierte Vorgaben eingeschränkt werden kann und wobei die Bauelementvarianz bestimmbar ist als Summe der Anzahlen der auf den Bestückungslinien benötigten Bauelementtypen, um eine minimale Bauelementvarianz bei vorgegebenen maximalen zeitlichen Auslastungen pro Bestückungslinie zu erreichen, und
- eine Einheit zum Berechnen der Zuordnung der Baugruppen auf die Bestückungslinien unter den gegebenen Vorgaben mittels ganzzahliger Linearen Programmierung, wobei die Berechnung der Zuordnung derart erfolgt, dass für die aus den genannten Wahrscheinlichkeitsverteilungen für die Stückzahlen resultierenden Wahrscheinlichkeitsverteilungen für die Summe der erwarteten Produktionszeiten pro Bestückungslinie die Abweichungen vom jeweiligen Erwartungswert dieser resultierenden Wahrscheinlichkeitsverteilungen durch einen vorgebbaren maximalen Schwellwert begrenzt sind, wobei

- eine Abweichung von der Summe der erwarteten Produktionszeiten einer Bestückungslinie als Varianz derselben bezeichnet wird, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann, und

wobei eine gewichtete Summe bestehend aus der Bauelementvarianz und aus der maximalen Abweichung von der Summe der erwarteten Produktionszeiten minimiert wird.

Die Vorrichtung kann Mittel und/oder Einheiten bzw. Einrich-tungen und/oder Module zur Durchführung des oben genannten Verfahrens vorsehen, die jeweils hardwaremäßig und/oder firm-waremäßig und/oder softwaremäßig bzw. als Computerprogramm bzw. Computerprogrammprodukt ausgeprägt sein können.

Die Vorrichtung kann wie das oben beschriebene Verfahren entsprechend aus- bzw. weitergebildet werden.

Ein weiterer Aspekt der Erfindung sieht eine Fertigungs- oder Montagelinienanordnung zur Bestückung von Baugruppen mit Bauelementen, wobei die Zuordnung der Baugruppen auf die Fertigungs- oder Montagelinie gemäß dem vorstehend erläuterten Verfahren bestimmt wird.

Diese Fertigungs- oder Montagelinienanordnung kann Teil einer Anlage sein.

Die Anlage kann unter anderem durch einen der folgenden Anlagentypen charakterisiert sein. Beispiele hierfür sind:

- eine Automatisierungsanlage,
- eine Fertigungs- bzw. Produktionsanlage,
- eine Reinigungsanlage,
- eine Wasseraufbereitungsanlage,
- ein Gerät oder eine Maschine,
- eine Strömungsmaschine,
- eine Energieerzeugungsanlage,
- ein Energienetz,
- ein Kommunikationsnetz,
- eine medizintechnische Einrichtung bzw. Gerät,
- ein Krankenhausinformationssystem.

Ein weiterer Aspekt der Erfindung ist ein Computerprogrammprodukt bzw. ein Computerprogramm mit Mitteln zur Durchführung des oben genannten Verfahrens, wenn das Computerprogramm(produkt) in einer oben genannten Vorrichtung zur Ausführung gebracht wird. Das Computerprogramm bzw. -produkt kann auf einem computerlesbaren Medium gespeichert sein. Das Computerprogramm bzw. -produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Vorrichtung oder in deren Mitteln integriert sein.

Weitere Vorteile, Einzelheiten und Weiterbildungen der Erfindung ergeben sich aus der nachfolgenden Beschreibung von Ausführungsbeispielen in Verbindung mit den Zeichnungen.

Es zeigen

FIG 1    ein erstes beispielhaftes Montagewerk mit Bestückungslinien zur Baugruppenfertigung,

FIG 2    eine Graphik für die Wahrscheinlichkeitsverteilungen hinsichtlich der Stückzahlen/Produktionszeiten der Linien 1 und 2 für eine Baugruppen-Linien-Zuordnung, und

FIG 3    eine Graphik für die besagten Wahrscheinlichkeitsverteilungen nach dem erfindungsgemäßen Optimierungsansatz für eine Baugruppen-Linien-Zuordnung.

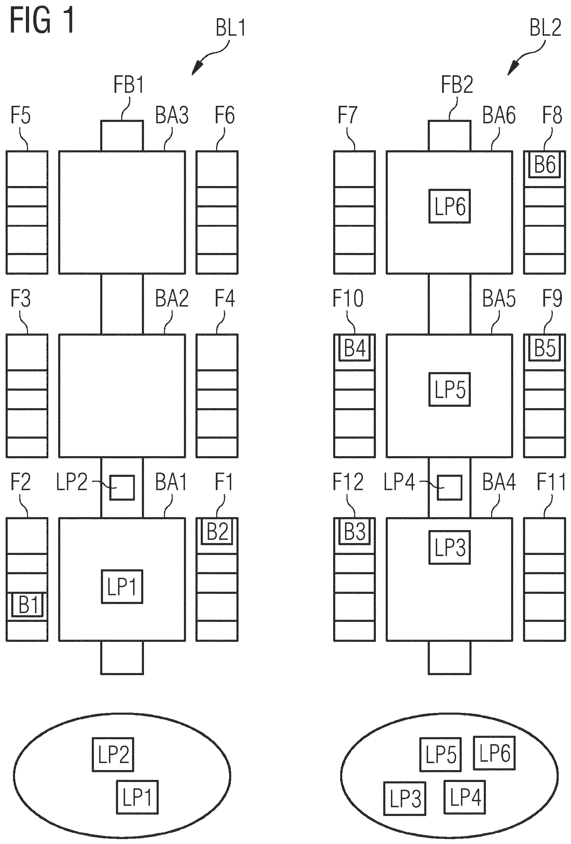

Figur 1 zeigt ein erstes beispielhaftes Montagewerk bzw. eine Montageanlage mit Bestückungslinien BL1 - BL2 zur Baugruppenfertigung. Eine Bestückungslinie BL1 - BL2 besteht üblicherweise aus Bestückungsautomaten BA1 - BA6, die jeweils durch ein Transportsystem FB1 - FB2 (z.B. Förderbänder) zum Transport der zu bestückenden Baugruppen bzw. Leiterplatten LP1 - LP6 mit einander verbunden sind. Die auf die Baugruppen LP1 - LP6 zu bestückenden Bauelemente bzw. Bauteile B1 - B6 werden üblicherweise über Förderer F1 - F11 an den Bestückungsautomaten BA1 - BA6 bereitgestellt. Dabei kann einer Bestückungslinie BL1, BL2 mehrere Baugruppen LP1 - LP6 von einem bestimmten Baugruppentyp r aus einer Menge von Baugruppentypen R ($r \in$ R) zugeordnet werden.

Bei Bestückungsautomaten BA1 - BA6 z.B. zum Bestücken von Substraten mit Bauelementen B1 - B6 sind seitlich an einer Transportstrecke für die Substrate Zuführvorrichtungen F1 - F11 für Bauelemente B1 - B6 angeordnet. Ein durch ein Positioniersystem verfahrbarer Bestückungskopf des Bestückungsautomaten BA1 - BA6 holt die Bauelemente B1 - B6 von den Zuführvorrichtungen F1 - F11 ab, verfährt diese zu einem Bestückungsbereich des Bestückungsautomaten, in dem das zu bestückende Substrat bereitgestellt ist, und setzt die Bauelemente B1 - B6 auf dem Substrat ab. Für die Bereitstellung der Bauelemente B1 - B6 werden z.B. sogenannte Gurt-Feeder eingesetzt, welche zum Transport und Zuführen von in Gurten gelagerten Bauteilen geeignet sind. Diese transportieren die in taschenartigen Vertiefungen magazinierten Bauteile zu einer Abholposition, an der die Bauteile von dem Bestückungskopf aus den Gurttaschen abgeholt werden. Der leere Gurt verlässt die Zuführvorrichtung F1 - F11 an einer geeigneten Stelle.

In vielen Werken im Bereich der Elektronikproduktion werden zu fertigende Leiterplatten bzw. Baugruppen mittelfristig auf die SMT-Bestücklinien (Surface Mounting Technology) der jeweiligen Werke zugewiesen. Auf Grund von technischen Restriktionen kann nicht jede Leiterplatte auf jeder Linie gefertigt werden. Die Leiterplatten besitzen auf den Linien meist auch unterschiedliche Produktionszeiten. Zudem dürfen die maximalen Produktionszeitkapazitäten der Linien nicht überschritten werden.

Bei der Zuordnung werden folgende Ziele verfolgt:
Die Anzahl der Rüstfamilien an den Linien soll möglichst gering sein, um den zeitlichen Umrüstaufwand zu reduzieren.

- Man möchte möglichst wenig Rüstequipment (z.B. Förderer) benötigen.
- Die Gesamtproduktionszeit sollte möglichst minimal sein.

Diese Ziele versucht man gewöhnlich zu erreichen, indem eine möglichst hohe Bauelementüberdeckung der Leiterplatten einer Linie angestrebt wird, bzw. die Summe der Bauelementvarianzen der Linien minimiert wird. Mit der Bauelementvarianz einer Linie wird die Anzahl der auf der Linie verwendeten Bauelementtypen bezeichnet.

Im Folgenden werden IP-Modelle (IP steht für Integer Programmierung bzw. für Integer Programm oder ganzzahliges Optimierungsmodell) für diese Problemstellung beschrieben. Als mathematische Optimierungsmethode können IP-Modelle (IP steht für Integer Programmierung bzw. für Integer Programm oder ganzzahliges Optimierungsmodell) für diese Problemstellung eingesetzt werden. Solche IP-Lösungsansätze weisen folgende Vorteile auf:

- Globaler Optimierungsansatz.
- Leicht erweiterbar.
- Sehr gute kommerzielle Standard-Solver (z.B. Cplex, Gurobi), die in der Praxis weit verbreitet und bewährt sind.
- Die Standard-Solver werden laufend verbessert, so dass zu erwarten ist das die Instanzen in Zukunft noch schneller lösbar sind.

Ferner wird ein IP-basiertes Verfahren vorgestellt, mit dem sich dafür Lösungen mit sehr guter Ergebnisgüte in relativ kurzer Laufzeit finden lassen.

Das im Folgenden dargestellte IP-Modell ist nur als eine mögliche beispielhafte Formulierung anzusehen und stellt keine Einschränkung für das Verfahren dar.

Es sei $L$ die Menge aller (Bestückungs-)linien und $R$ die Menge aller Baugruppentypen und $R_l$ die Menge der bestückbaren Baugruppentypen auf Line l. Zudem ist C die Menge der Bauelementetypen c und $R_c$ drückt die Menge der Baugruppentypen mit Bauelementetyp c aus.

Es werden folgende Parameter verwendet:

$TimeLimit_l$ Produktionszeitschranke auf der Bestücklinie $l$

$w_S$ Gewichtungsfaktor für die Minimierung der Bauelementvarianz.

$w_V$ Gewichtungsfaktor für die Minimierung der maximalen Produktions zeit-Varianz.

Binärvariablen sind:

$Assign_{r,l}$ Zuordnung des Baugruppentyps r zu Bestücklinie *1*.

$Setup_{c,l}$ Verwendung eines Bauelements c auf einer Linie $l$ (Bei Verwendung nimmt sie den Wert 1, anderenfalls den Wert 0 an).

Im Planungszeitraum sollen auf mehreren SMT-Linien eine Menge von Baugruppen mit Bauelementen verschiedener Bauelementtypen bestückt werden. Für jeden Baugruppentyp r wird geschätzt, wie viele Aufträge es dazu geben wird. Die tatsächliche zu produzierende Stückzahl eines Baugruppentyps wird gemäß einer Wahrscheinlichkeitsverteilung auftreten, die z.B. aus historischen Daten oder Prognosen ermittelt werden kann. Mit den Taktzeiten auf den verschiedenen (Bestückungs-)linien, den geschätzten Umrüstzeiten und den Linien-Nutzungsgraden lassen sich Wahrscheinlichkeitsverteilungen für die Gesamtproduktionszeiten pro Baugruppentyp und Linie ermitteln, die als Eingabe dienen können. Pro Linie wird zudem eine maximale Produktionszeit im Planungszeitraum vorgegeben. Die erwartete Produktionszeit pro Baugruppentyp kann mit einer in den Figuren nicht dargestellten Einheit ermittelt werden. Eine solche Einheit kann in einen Bestückungsautomaten z.B. BA1 der Bestückungslinie BL1 integriert sein. Auch eine nicht dargestellte Einheit zum Berechnen der Zuordnung der Baugruppen auf Bestückungslinien kann in solchen einen Bestückungsautomaten integriert sein.

Diese Einheiten können auch in einen separiert von den Bestückungsautomaten stehenden Computer implementiert bzw. integriert sein, der die Bestückungsautomaten steuert.

Ziel ist es zudem, Produktionszeitschwankungen der einzelnen Linien zu beschränken oder diese so weit wie möglich zu minimieren.

Im Ausführungsbeispiel werden folgende weitere Parameter im IP-Modell verwendet:

$n_r$      Unabhängige Zufallsvariable für die zu produzierende Stückzahl n des Baugruppentyps r innerhalb eines bestimmten Zeitraums.

$c_r$      Fixe Produktionszeit bei der Produktion einer beliebigen Stückzahl des Baugruppentyps r.

$t_{r,l}$      Taktzeit für die Produktion einer Baugruppe des Baugruppentyps r an Linie *1.*

$VarMax_l$      Maximale Produktionszeit-Varianz auf der Bestücklinie *1.*

p      Prozentwert für die maximal zulässigen Unterschiede der Produktionszeit-Varianzen auf den Linien.

Kontinuierliche Hilfsvariablen:

$V_{Max}$      Maximale Produktionszeit-Varianz auf allen Linien.
$V_{Min}$      Minimale Produktionszeit-Varianz auf allen Linien.

Es wird angenommen, dass die Produktionszeit einer Baugruppe auf einer Linie $t_{r,l}n_r + c_r$ beträgt. Dabei ist $c_r$ ein konstanter Anteil, in dem zum Beispiel die Umrüstzeiten enthalten sind. Die Produktionszeiten der Baugruppe auf einer Linie sind auch unabhängige Zufallsvariablen.

Für eine Menge $R_l' \subseteq R_l$ von Baugruppentypen *r*, die einer Linie *l* zugewiesen sind, ist die Produktionszeit folglich auch eine Zufallsvariable, für dessen Varianz gilt:

$$Var(Produktionszeit\ Linie\ l) = Var\left( \sum_{r \in R_l'} t_{r,l}n_r + c_r \right)$$

$$= \sum_{r \in R_l'} t^2_{r,l} Var(n_r)$$

In einem IP-Modell werden in der Regel Restriktionen verwendet. Folgende Restriktionen des IP-Modells beschränken die erwartete Produktionszeit auf den Linien und gewährleisten die Zulässigkeit der Lösung:

$$\sum_{r \in R} EW\left(t_{r,l}n_r + c_r\right) Assign_{r,l} \leq TimeLimit_l \qquad\qquad l \in L$$

Die Restriktionen

$$Assign_{r,l} = 0 \qquad\qquad l \in L, r \in R \backslash R_l$$

garantieren, dass Baugruppen nur Bestückungslinien zugewiesen werden können, auf denen sie auch bestückbar sind.

Durch die Restriktionen

$$\sum_{l \in L} Assign_{r,l} = 1 \qquad r \in R$$

wird jeder Baugruppentyp genau einer Bestückungslinie zugeordnet.

Im IP-Modell lässt sich zudem die Produktionszeit-Varianz einer Bestückungslinie folgendermaßen ausdrücken:

$$Var(Produktionszeit\ Linie\ l) = \sum_{r \in R_l} t_{r,l}^2 Var(n_r)\ Assign_{r,l} \qquad l \in L$$

Es sind folgende Varianten zur Begrenzung der maximalen Produktionszeit-Varianz auf den Linien möglich:

(1) Durch fest vorgegebene Parameter $VarMax_l$ lassen sich die Produktionszeitvarianzen für alle Linien $l$ begrenzen durch die zusätzlichen Restriktionen

$$\sum_{r \in R_l} t_{r,l}^2 Var(n_r) Assign_{r,l} \leq VarMax_l \qquad l \in L$$

(2) Es kann mit einer Hilfsvariable $V_{max}$ und zusätzlichen Restriktionen

$$\sum_{r \in R_l} t_{r,l}^2 Var(n_r) Assign_{r,l} \leq V_{max} \qquad l \in L$$

durch Minimierung von $V_{max}$ erreicht werden, dass die maximale Produktionszeitvarianz der Linien so weit wie möglich minimiert wird. $V_{max}$ kann dabei mit einem Gewichtsfaktor $w_v$ in die Zielfunktion des IP-Modells aufgenommen werden.

(3) Eine weitere Möglichkeit ist, für einen vorgegebenen Prozentwert p, die Abweichung der maximalen und der minimalen Varianz der Linien zu beschränken.

Dazu sei $V_{min}$ eine weitere Hilfsvariable. Zusätzliche Restriktionen sind

$$V_{min} \leq \sum_{r \in R_l} t_{r,l}^2 Var(n_r) Assign_{r,l} \qquad l \in L$$

und

$$V_{max} - V_{min} \leq \frac{p}{100} V_{max}$$

Mit den oben dargestellten Restriktionen der Varianten (1) und (3) kann zudem jeweils das IP-Modell aus DE 10 2011 076 565 B4, WO2014/005741 A1, WO2014/005743 A1, WO2014/005744 A1 erweitert werden. Die aus den genannten Dokumenten bekannten Methoden sind Beispiele für Optimierungsmethoden mittels MIP für Zuordnungen von Baugruppen auf Bestückungslinien.

Demnach können auch in diesen IP-Modellen Produktionszeitschwankungen eingeschränkt werden. Mit der Variante (2) können diese IP-Modelle ebenfalls erweitert werden, indem zusätzlich zu den neuen Restriktionen $V_{max}$ mit einer gewählten Gewichtung in die Zielfunktion mit aufgenommen wird.

Die ganzzahlige lineare Programmierung kann durch folgende Schritte gelöst wird:

a) Ermitteln einer Startlösung bzw. ersten aktuellen Lösung,
b) Zuordnen von einer ausgewählten Menge von Baugruppen LP1-L6 auf die Bestückungslinien BL1 - BL2, basierend auf einer aktuellen Lösung,
c) Berechnen der neuen Zuordnungen mittels eines Optimierungsprogrammes oder eines Standardsolvers basierend auf ganzzahliger linearer Programmierung.

Die Schritte können iterativ durchgeführt werden und ein Programmabbruch erfolgt, wenn eine vorher festgelegte Zeitgrenze oder Ergebnisgüte erreicht wird.

Folgende Varianten der erweiterten IP-Formulierung sind möglich:

IP-Formulierung zur Variante (1):

$$\text{minimize} \sum_{c \in C} \sum_{l \in L} \text{Setup}_{c,cl}$$

Unter den Bedingungen:

$$\sum_{l \in L} \text{Assign}_{r,l} = 1 \qquad\qquad r \in R$$

$$\text{Assign}_{r,l} = 0 \qquad\qquad l \in L, r \in R \wedge r \notin R_l$$

$$\sum_{r \in R_c} \text{Assign}_{r,l} \leq |R_c| \, \text{Setup}_{c,cl} \qquad\qquad c \in C, l \in L$$

$$\sum_{r \in R} EW\,(t_{r,l}\,n_r + c_r)\,\text{Assign}_{r,l} \leq \text{TimeLimit}_l \qquad\qquad r \in R$$

$$\sum_{r \in R_l} t_{r,l}^2 \, \text{Var}(n_r)\,\text{Assign}_{r,l} \leq \text{VarMax}_l \qquad\qquad l \in L$$

$$\text{Setup}_{c,cl} \in \{0,1\} \qquad\qquad c \in C, l \in L$$

$$\text{Assign}_{r,l} \in \{0,1\} \qquad\qquad r \in R, l \in L$$

und IP-Formulierung zu den Varianten (2) und (3):

$$\text{minimize}\;\; w_V V_{\text{Max}} + w_S \sum_{c \in C} \sum_{l \in L} \text{Setup}_{c,cl}$$

Unter den Bedingungen:

$$\sum_{l \in L} \text{Assign}_{r,l} = 1 \qquad\qquad r \in R$$

$$\text{Assign}_{r,l} = 0 \qquad\qquad l \in L, r \in R \setminus R_l$$

$$\sum_{r \in R_c} \text{Assign}_{r,l} \leq |R_c| \, \text{Setup}_{c,cl} \qquad\qquad c \in C, l \in L$$

$$\sum_{r \in R} EW(t_{r,l}\, n_r + c_r)\, \text{Assign}_{r,l} \leq \text{TimeLimit}_l \qquad\qquad r \in R$$

$$\sum_{r \in R_l} t_{r,l}^2 \, \text{Var}(n_r)\, \text{Assign}_{r,l} \leq V_{\text{Max}} \qquad\qquad l \in L$$

$$\sum_{r \in R_l} t_{r,l}^2 \, \text{Var}(n_r)\, \text{Assign}_{r,l} \geq V_{\text{Min}} \qquad\qquad l \in L$$

$$V_{\text{Max}} - V_{\text{Min}} \leq \frac{p}{100} V_{Max} \qquad\qquad l \in L$$

$$\text{Setup}_{c,cl} \in \{0,1\} \qquad\qquad c \in C, l \in L$$

$$\text{Assign}_{r,l} \in \{0,1\} \qquad\qquad r \in R, l \in L$$

$$V_{\text{Max}} \geq 0$$

$$V_{\text{Min}} \geq 0$$

Im Folgenden wird ein vereinfachtes Beispiel erläutert, das den oben komplex dargestellten Optimierungsprozess hinsichtlich der Minimierung der Bauelementvarianz unter Beschränkung der Produktionszeitschwankungen zum Verständnis in vereinfachter Weise erläutern soll, ohne auf dieses vereinfachtes Beispiel beschränkt zu sein. Überträgt man das nachstehend beschriebene einfache Beispiel mit wenigen Instanzen auf größere Instanzen bzw. komplexere Problemstellungen ist eine gute bzw. genaue Auswahl an Parametern im IP-Modell mit den anzuwendenden Restriktionen bzw. den benutzerdefinierten Vorgaben wesentlich, um eine Lösung der komplexen Problemstellung mit den erwähnten Standardsolvern überhaupt bzw. optimiert erzielen zu können.

Es wird im folgenden Beispiel angenommen, dass für einen Baugruppentyp bei einer prognostizierten Stückzahl n die tatsächlich zu fertigende bzw. zu bestückenden Stückzahl gemäß der folgenden Wahrscheinlichkeitsverteilung schwankt:

- Mit einer Wahrscheinlichkeit von 0,8 wird der prognostizierte Wert n angenommen.
- Mit einer Wahrscheinlichkeit von jeweils 0,1 wird eine 10%ige Abweichung des Wertes n nach oben bzw. unten angenommen.

Es sollen sechs verschiedene Baugruppentypen zu zwei Linien BL 1 und BL 2 zugeordnet werden. Die prognostizierten Stückzahlen n sind:

| r1 | r2 | r3 | r4 | r5 | r6 |
|------|------|------|------|------|------|
| 2000 | 2000 | 1000 | 1000 | 1000 | 1000 |

Die Baugruppentypen sollen mit den Bauelementetypen c1-c9 gemäß der folgenden Tabelle bestückt werden:

| | c1 | c2 | c3 | c4 | c5 | c6 | c7 | c8 | c9 |
|---|---|---|---|---|---|---|---|---|---|

(fortgesetzt)

| | | | | | | | | | |
|---|---|---|---|---|---|---|---|---|---|
| r1 | X | X | | | | | | | |
| r2 | | X | X | | | | | | |
| r3 | | | | X | X | | | | |
| r4 | | | | X | X | X | | | |
| r5 | | | | | | | X | X | |
| r6 | | | | | | | | X | X |

Die Zuordnung soll so erfolgen, dass die beiden Linien gleich ausgelastet sind, d.h. gleiche erwartete Produktionszeiten besitzen. Die Taktzeiten betragen für alle Baugruppentypen 1 min, somit beträgt z.B. die Produktionszeit 1000 min bei einer Stückzahl von 1000.

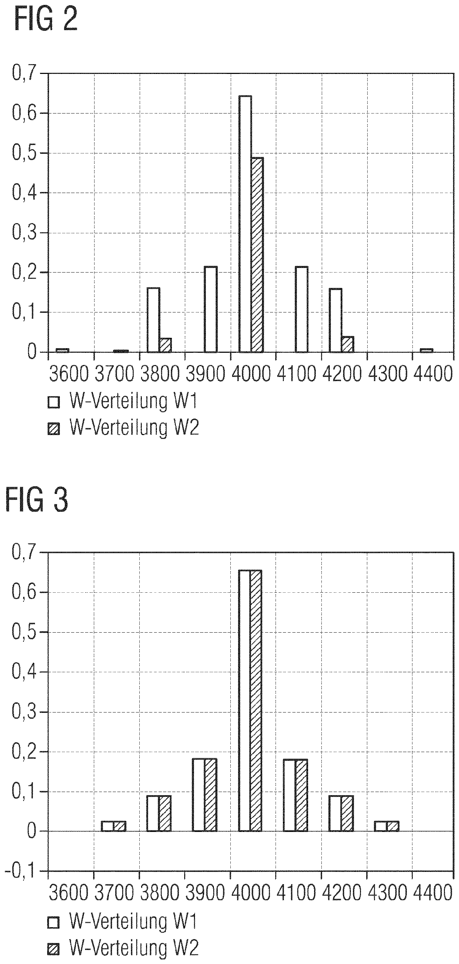

Ist das Zielkriterium die Minimierung der Bauelementvarianz, so werden r1 und r2 auf die Linie BL1 und die Baugruppen r3 bis r6 auf die Linie BL2 zugeordnet, da damit auf der Linie BL1 die Bauelementtypen c1-c3 und auf der Linie BL2 die Bauelementtypen c4-c9 benötigt werden und sich insgesamt eine minimale Bauelementvarianz von 9 ergibt. Es ergeben sich damit folgende Wahrscheinlichkeits-Verteilungen W1 und W2 der Stückzahlen/Produktionszeiten auf beiden Linien BL1 und BL2, wie es in folgender Tabelle bzw. in Figur 2 dargestellt ist.

| | W-Verteilung von BL1 | W-Verteilung von BL2 |
|---|---|---|
| 3600 | 0,01 | 0,0001 |
| 3700 | | 0,0032 |
| 3800 | 0,16 | 0,0388 |
| 3900 | | 0,2144 |
| 4000 | 0,64 | 0,487 |
| 4100 | | 0,2144 |
| 4200 | 0,16 | 0,0388 |
| 4300 | | 0,0032 |
| 4400 | 0,01 | 0,0001 |

Auf Linie BL1 ergibt sich durch die beiden Baugruppentypen mit hohen Stückzahlen eine hohe Schwankungsbreite für die Stückzahlen/Produktions zeiten.

Die Varianz hinsichtlich der Produktionszeit auf der Linie BL1 ist maximal und beträgt:

$$2 * (400^2 * 0{,}01 + 200^2 * 0{,}16) = 16000$$

Beschränkt man zusätzlich die Varianzen hinsichtlich der Produktionszeiten durch die in (1) aufgeführten Restriktionen auf allen Linien auf 12000, so werden die Baugruppentypen r1, r3 und r4 der Linie BL1 und die Baugruppentypen r2, r5 und r6 der Linie BL2 zugeordnet.

Es ergeben sich damit folgende Wahrscheinlichkeits-Verteilungen W1 und W2 der Stückzahlen/Produktionszeiten auf den beiden Linien BL1 und BL2, wie es in der folgenden Tabelle und in Figur 3 dargestellt ist.

| | W-Verteilung von BL1 | W-Verteilung von BL2 |
|---|---|---|
| 3600 | 0,001 | 0,001 |
| 3700 | 0, 016 | 0,016 |
| 3800 | 0,074 | 0,074 |
| 3900 | 0,144 | 0,144 |
| 4000 | 0,53 | 0,53 |

(fortgesetzt)

|  | W-Verteilung von BL1 | W-Verteilung von BL2 |
|---|---|---|
| 4100 | 0,144 | 0,144 |
| 4200 | 0,074 | 0,074 |
| 4300 | 0, 016 | 0,016 |
| 4400 | 0,001 | 0,001 |

Die maximale Varianz hinsichtlich der Produktionszeiten verringert sich bei dieser zweiten Zuordnung um 25% auf

$$2 * (400^2 * 0,001 + 300^2 * 0,016 + 200^2 * 0,074 + 100^2 * 0,144) = 12000$$

In der Mitte und am Rand sind die Werte der Verteilungen für Linie BL1 und Linie BL2 bei der zweiten Baugruppenlinien-Zuordnung deutlich niedriger als die Werte der Verteilung für Linie BL1 bei der ersten Baugruppenlinien-Zuordnung. Am Rand ist die Wahrscheinlichkeit sogar nur noch ein Zehntel.

Bei der zweiten Zuordnung werden auf der Linie BL1 die Bauelementtypen c1-c2 und c4-c6 und auf der Linie BL2 die Bauelementtypen c2-c3 und c7-c9 benötigt. Insgesamt ergibt sich somit eine Bauelementvarianz von 10.

Im Vergleich zur ersten Zuordnung hat sich die Summe der auf den Linien benötigten Bauelementtypen nur von 9 auf 10 erhöht, während sich die maximale Varianz hinsichtlich der Produktionszeiten auf den Linien deutlich von 16000 auf 12000 verringert hat.

Bei einer geeigneten Parameterwahl kann gezielt die oben erläuterte zweite Baugruppenlinien-Zuordnung ermittelt werden. Die Schritte der Optimierung können iterativ durchgeführt werden und ein Programmabbruch kann erfolgen, wenn eine zuvor festgelegte Zeitgrenze oder eine vorgebbare Ergebnisgüte erreicht wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den durch die angehängten Ansprüche definierten Schutzumfang der Erfindung zu verlassen.

**Patentansprüche**

1. Computergestütztes Verfahren zur Zuordnung von Baugruppen (LP1 - LP6) auf Bestückungslinien (BL1 - BL6) zur Bestückung der Baugruppen (LP1 - LP6) mit Bauelementen (B1 - B6), um eine minimale Bauelementvarianz bei vorgegebenen maximalen zeitlichen Auslastungen pro Bestückungslinie (BL1 - BL2) zu erreichen, wobei die Bauelementvarianz bestimmt wird als Summe der Anzahlen der auf den Bestückungslinien (BL1 - BL2) benötigten Bauelementtypen, wobei für jeden Baugruppentyp der zu bestückenden Baugruppen (LP1 - LP6) und jede Bestückungslinie (BL1 - BL2) unter Berücksichtigung der jeweiligen Taktzeit des Baugruppentyps auf der Bestückungslinie (BL1 - BL2), den jeweiligen Umrüstzeiten, dem jeweiligen Liniennutzungsgrad und der pro Baugruppentyp erwarteten zu produzierenden Stückzahl eine erwartete Produktionszeit ermittelt wird,

wobei die tatsächliche zu produzierende Stückzahl gemäß einer vorher bestimmbaren Wahrscheinlichkeitsverteilung auftritt, wobei für die einer Linie (BL1 - BL2) zugeordneten Menge von Baugruppen (LP1 - LP6) die Summe dieser erwarteten Gesamtproduktionszeiten die maximale zeitliche Auslastung der jeweiligen Bestückungslinie (BL1 - BL2) nicht überschreiten darf, wobei die möglichen Zuordnungen von Baugruppen (LP1 - LP6) auf die Bestückungslinien (BL1 - BL2) durch die vorhandene Infrastruktur oder durch benutzerdefinierte Vorgaben eingeschränkt sind,
wobei die Zuordnung derart erfolgt, dass für die aus den genannten Wahrscheinlichkeitsverteilungen für die Stückzahlen resultierenden Wahrscheinlichkeitsverteilungen für die Summe der erwarteten Produktionszeiten pro Bestückungslinie die Abweichungen vom jeweiligen Erwartungswert dieser resultierenden Wahrscheinlichkeitsverteilungen durch einen vorgebbaren maximalen Schwellwert begrenzt sind, wobei
eine Abweichung von der Summe der erwarteten Produktionszeiten einer Bestückungslinie als Varianz derselben bezeichnet wird, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann, und

wobei die Zuordnung der Baugruppen (LP1 - LP6) auf die Bestückungslinien (BL1 - BL1) unter den gegebenen Vorgaben mittels ganzzahliger Linearen Programmierung berechnet wird,

wobei eine gewichtete Summe bestehend aus der Bauelementvarianz und aus der maximalen Abweichung von der Summe der erwarteten Produktionszeiten minimiert wird.

2. Computergestüztes Verfahren nach dem vorhergehenden Anspruch, wobei die Summe der erwarteten Produktionszeiten der Bestückungslinien (BL1 - BL1) mittels ganzzahliger linearer Programmierung minimiert wird.

3. Computergestütztes Verfahren nach einem der vorhergehenden Ansprüche, **dadurch gekennzeichnet, dass** die genannten Abweichungen von den Erwartungswerten der resultierenden Wahrscheinlichkeitsverteilungen ähnliche oder gleiche Werte annehmen.

4. Computergestütztes Verfahren nach einem der vorhergehenden Ansprüche, wobei vom Benutzer vorgegebene Mengen von Baugruppen (LP1- LP6) auf dieselbe Bestückungslinie (BL1 - BL2) zugeordnet werden.

5. Computergestütztes Verfahren nach einem der vorstehenden Ansprüche, wobei als Eingabedaten für die ganzzahliger Lineare Programmierung folgende, die Infrastruktur beschreibende, Daten verwendet werden:

- Anzahl der Bestückungslinien (BL1 - BL2),
- Anzahl der Baugruppen (LP1- LP6),
- Anzahl der Baugruppentypen,
- Anzahl der Bauelementtypen,
- Menge der zu bestückende Bauelementtypen pro Baugruppentyp,
- Produktionszeitschranke pro jeweiliger Bestückungslinie (BL1 - BL2),
- Wahrscheinlichkeitsverteilungen für die erwarteten Stückzahlen der Baugruppentypen.

6. Computergestütztes nach einem der vorstehenden Ansprüche, wobei die Gesamtproduktionszeit für einen jeweiligen Baugruppentyp auf einer jeweiligen Bestückungslinie (BL1 - BL2) berechnet wird aus:

- der Anzahl der zu erwartenden Aufträge,
- der Losgrößen,
- der Umrüstzeiten,
- der Einzelproduktionszeiten pro Baugruppe (LP1- LP6) und Bestückungslinie (BL1 - BL1),
- minimale Taktzeiten der Bestückungslinien (BL1 - BL2),
- Nutzungsgrade der Bestückungslinien (BL1 - BL2).

7. Computergestütztes Verfahren nach einem der vorstehenden Ansprüche, wobei die Lineare Programmierung mittels eines ganzzahligen Linearen Programms eingestellt wird, das durch folgende Schritte gelöst wird:

a) Ermitteln einer ersten aktuellen Lösung, die eine Zuordnung von Baugruppen auf Produktionslinien repräsentiert,
b) Zuordnen von einer ausgewählten Menge von Baugruppen (LP1-LP6) auf die Bestückungslinien (BL1-BL2), basierend auf einer aktuellen Lösung,
c) Berechnen der neuen Zuordnungen mittels eines Optimierungsprogrammes oder eines Standardsolvers basierend auf ganzzahliger linearer Programmierung.

8. Computergestütztes Verfahren nach dem vorhergehenden Anspruch, wobei die Schritte iterativ durchgeführt werden und ein Programmabbruch erfolgt, wenn eine vorher festgelegte Zeitgrenze oder Lösungsgüte erreicht worden ist.

9. Vorrichtung zur Zuordnung von Baugruppen (LP1 - LP6) auf Bestückungslinien (BL1 - BL2) zur Bestückung der Baugruppen (LP1 - LP6) mit Bauelementen (B1 - B6), aufweisend:

- eine Einheit zum Ermitteln einer erwarteten Produktionszeit für jeden Baugruppentyp der zu bestückenden Baugruppen (LP1 - LP6) und für jede Bestückungslinie (BL1 - BL2) unter Berücksichtigung der jeweiligen Taktzeit des Baugruppentyps auf der Bestückungslinie (BL1 - BL2) und der pro Baugruppentyp erwarteten zu produzierenden Stückzahl, wobei die tatsächliche zu produzierende Stückzahl gemäß einer vorher bestimmbaren Wahrscheinlichkeitsverteilung auftreten kann, wobei für die einer Linie (BL1 - BL2) zugeordneten Menge von Baugruppen (LP1 - LP6) die Summe dieser erwarteten Gesamtproduktionszeiten die maximale zeitliche Auslastung der jeweiligen Bestückungslinie (BL1 - BL2) nicht überschreiten darf, wobei die möglichen Zuordnungen von Baugruppen (LP1 - LP6) auf Bestückungslinien (BL1 - BL2) durch die vorhandene Infrastruktur und/oder durch benutzerdefinierte Vorgaben eingeschränkt werden kann und wobei die Bauelementvarianz bestimmbar ist als Summe der Anzahlen der auf den Bestückungslinien (BL1 - BL2) benötigten Bauelementtypen , um eine minimale Bauelementvarianz bei vorgegebenen maximalen zeitlichen Auslastungen pro Bestückungslinie (BL1 - BL2) zu erreichen, und

- eine Einheit zum Berechnen der Zuordnung der Baugruppen (LP1 - LP6) auf die Bestückungslinien (BL1 - BL2) unter den gegebenen Vorgaben mittels ganzzahliger Linearen Programmierung, wobei die Berechnung der Zuordnung derart erfolgt, dass für die aus den genannten Wahrscheinlichkeitsverteilungen für die Stückzahlen resultierenden Wahrscheinlichkeitsverteilungen für die Summe der erwarteten Produktionszeiten pro Bestückungslinie die Abweichungen vom jeweiligen Erwartungswert dieser resultierenden Wahrscheinlichkeitsverteilungen durch einen vorgebbaren maximalen Schwellwert begrenzt sind, wobei eine Abweichung von der Summe der erwarteten Produktionszeiten einer Bestückungslinie als Varianz derselben bezeichnet wird, welche pro Bestückungslinie durch die Summe über alle Baugruppentypen, die der Bestückungslinie zugeordnet sind, aus dem Produkt der quadratischen Abweichung von der erwartenden Stückzahl eines Baugruppentyps innerhalb eines Zeitraums und den dazugehörigen Werten der resultierenden Wahrscheinlichkeitsverteilungen und multipliziert mit der quadrierten Taktzeit bestimmt werden kann, und

wobei eine gewichtete Summe bestehend aus der Bauelementvarianz und aus der maximalen Abweichung von der Summe der erwarteten Produktionszeiten minimiert wird.

10. Vorrichtung nach dem vorhergehenden Anspruch, **dadurch gekennzeichnet, dass** die genannten Abweichungen von den Erwartungswerten der resultierenden Wahrscheinlichkeitsverteilungen ähnliche oder gleiche Werte annehmen können.

11. Vorrichtung nach einem der vorhergehenden Vorrichtungsansprüche, wobei vom Benutzer vorgegebene Mengen von Baugruppen (LP1- LP6) auf dieselbe Bestückungslinie (BL1 - BL2) zugeordnet werden können.

12. Computerprogramm mit Mitteln zur Durchführung des Verfahrens nach einem der vorgenannten Verfahrensansprüche, wenn das Computerprogramm auf einer Vorrichtung einem der vorgenannten Vorrichtungsansprüche zur Ausführung gebracht wird.

13. Computerlesbares Medium, umfassend Anweisungen, welche, wenn sie auf der nach einem der vorhergehenden Vorrichtungsansprüche ausgeführt werden, die Vorrichtung dazu bringen, das Verfahren gemäß einem der vorhergehenden Verfahrensansprüche auszuführen.

**Claims**

1. Computer-aided method for assigning assemblies (LP1 - LP6) to component fitting lines (BL1 - BL6) for fitting the assemblies (LP1 - LP6) with components (B1 - B6) in order to achieve a minimal component variance for prescribed maximum utilization levels over time per component fitting line (BL1 - BL2), wherein the component variance is determined as the sum of the numbers of component types needed on the component fitting lines (BL1 - BL2), wherein an expected production time is ascertained for each assembly type of the assemblies (LP1 - LP6) to be fitted with components and each component fitting line (BL1 - BL2) taking into consideration the respective cycle time for the assembly type on the component fitting line (BL1 - BL2), the respective conversion times, the respective level of line use and the expected number of items to be produced per assembly type,

wherein the actual number of items to be produced arises according to a previously determinable probability distribution,
wherein the sum of these expected total production times must not exceed the maximum utilization level of the respective component fitting line (BL1 - BL2) over time for the set of assemblies (LP1 - LP6) that is assigned to a line (BL1 - BL2),
wherein the possible assignments of assemblies (LP1 - LP6) to the component fitting lines (BL1 - BL2) are limited by the existing infrastructure or by user-defined presets, wherein the assignment is made such that for the probability distributions for the sum of the expected production times per component fitting line that result from the cited probability distributions for the numbers of items, the differences from the respective expected value of these resultant probability distributions are limited by a prescribable maximum threshold value, wherein a difference from the sum of the expected production times of a component fitting line is expressed as a variance thereof, which can be determined per component fitting line by the sum over all component types assigned to the component fitting line, from the product of the square difference from the expected number of items of a component type within a period of time and the associated values of the resultant probability distributions and with multiplication by the squared cycle time,

and

wherein the assignment of the assemblies (LP1 - LP6) to the component fitting lines (BL1 - BL1) is computed for the given presets by means of integer linear programming, wherein a weighted sum consisting of the component variance and the maximum difference from the sum of the expected production times is minimized.

2. Computer-aided method according to the preceding claim,
wherein the sum of the expected production times of the component fitting lines (BL1 - BL1) is minimized by means of integer linear programming.

3. Computer-aided method according to either of the preceding claims, **characterized in that** the cited differences from the expected values of the resultant probability distributions assume similar or like values.

4. Computer-aided method according to one of the preceding claims, wherein user-prescribed sets of assemblies (LP1 - LP6) are assigned to the same component fitting line (BL1 - BL2).

5. Computer-aided method according to one of the preceding claims, wherein the input data used for the integer linear programming are the following data describing the infrastructure:

    - number of component fitting lines (BL1 - BL2),
    - number of assemblies (LP1 - LP6),
    - number of assembly types,
    - number of component types,
    - set of component types to be fitted per assembly type,
    - production time limit per respective component fitting line (BL1 - BL2),
    - probability distributions for the expected numbers of items of the assembly types.

6. Computer-aided method according to one of the preceding claims, wherein the total production time for a respective assembly type on a respective component fitting line (BL1 - BL2) is computed from:

    - the number of jobs to be expected,
    - the batch sizes,
    - the conversion times,
    - the individual production times per assembly (LP1 - LP6) and component fitting line (BL1 - BL1),
    - minimum cycle times of the component fitting lines (BL1 - BL2),
    - levels of use of the component fitting lines (BL1 - BL2).

7. Computer-aided method according to one of the preceding claims, wherein the linear programming is set by means of an integer linear program solved by the following steps:

    a) ascertaining a first current solution representing an assignment of assemblies to production lines,
    b) assigning a selected set of assemblies (LP1 - LP6) to the component fitting lines (BL1 - BL2), based on a current solution,
    c) computing the new assignments by means of an optimization program or a standard solver based on integer linear programming.

8. Computer-aided method according to the preceding claim, wherein the steps are performed iteratively and a program termination takes place if a previously stipulated time limit or solution quality has been reached.

9. Apparatus for assigning assemblies (LP1 - LP6) to component fitting lines (BL1 - BL2) for fitting the assemblies (LP1 - LP6) with components (B1 - B6), having:

    - a unit for ascertaining an expected production time for each assembly type of the assemblies (LP1 - LP6) to be fitted with components and for each component fitting line (BL1 - BL2) taking into consideration the respective cycle time for the assembly type on the component fitting line (BL1 - BL2) and the expected number of items to be produced per assembly type, wherein the actual number of items to be produced can arise according to a previously determinable probability distribution, wherein the sum of these expected total production times must not exceed the maximum utilization level of the respective component fitting line (BL1 - BL2) over time for the set of assemblies (LP1 - LP6) that is assigned to a line (BL1 - BL2), wherein the possible assignments of assemblies (LP1 - LP6) to component fitting lines (BL1 - BL2) can be limited by the existing infrastructure and/or by user-defined presets and wherein the component variance is determinable as the sum of the numbers of component types needed on the component fitting lines (BL1 - BL2) in order to achieve a minimum component variance for prescribed maximum utilization levels over time per component fitting line (BL1 - BL2), and
- a unit for computing the assignment of the assemblies (LP1 - LP6) to the component fitting lines (BL1 - BL2) for the given presets by means of integer linear programming, wherein the assignment is computed such that for the probability distributions for the sum of the expected production times per component fitting line that result from the cited probability distributions for the numbers of items, the differences from the respective expected value of these resultant probability distributions are limited by a prescribable maximum threshold value, wherein

a difference from the sum of the expected production times of a component fitting line is expressed as a variance thereof, which can be determined per component fitting line by the sum over all component types assigned to the component fitting line, from the product of the square difference from the expected number of items of a component type within a period of time and the associated values of the resultant probability distributions and with multiplication by the squared cycle time, and
wherein a weighted sum consisting of the component variance and the maximum difference from the sum of the expected production times is minimized.

10. Apparatus according to the preceding claim, **characterized in that** the cited differences from the expected values of the resultant probability distributions can assume similar or like values.

11. Apparatus according to either of the preceding apparatus claims, wherein user-prescribed sets of assemblies (LP1 - LP6) can be assigned to the same component fitting line (BL1 - BL2).

12. Computer program having means for performing the method according to one of the aforementioned method claims when the computer program is executed on an apparatus according to one of the aforementioned apparatus claims.

13. Computer-readable medium, comprising instructions that, when executed on the apparatus according to one of the preceding apparatus claims, prompt the apparatus to perform the method according to one of the preceding method claims.

**Revendications**

1. Procédé assisté par ordinateur, destiné à la répartition d'assemblages de circuits (LP1 - LP6) sur des lignes de montage (BL1 - BL6) à des fins de montage des assemblages de circuits (LP1 - LP6) avec des composants (B1 - B6) dans le but d'obtenir une variance de composant minimale dans le cadre de charges temporelles prédéfinies par ligne de montage (BL1 - BL2) ; dans lequel on détermine la variance de composant sous la forme de la somme des nombres des types de composants requis sur les lignes de montage (BL1 - BL2) ; dans lequel, pour chaque type d'assemblage de circuits parmi les assemblages de circuits (LP1 - LP6) qui doivent faire l'objet d'un montage, et pour chaque ligne de montage (BL1 - BL2), en prenant en compte le temps de cycle respectif du type d'assemblage de circuits sur la ligne de montage (BL1 - BL2), des temps de réaménagement respectifs, du degré d'exploitation de ligne respectif, et du nombre de pièces à produire que l'on escompte par type d'assemblage de circuits, on détermine un temps de production escompté ; dans lequel on obtient le nombre de pièces réellement à produire en conformité avec une distribution de probabilités que l'on peut déterminer à l'avance ; dans lequel, pour la quantité des assemblages de circuits (LP1 - LP6) répartis sur une ligne de montage (BL1 - BL2), la somme de ces temps de production globaux que l'on escompte ne peut pas dépasser vers le haut la charge temporelle maximale de la ligne de montage respective (BL1 - BL2) ; dans lequel les répartitions possibles des assemblages de circuits (LP1 - LP6) sur les lignes de montage (BL1 - BL2) sont limitées par l'infrastructure en présence ou par des spécifications précisées par l'exploitant ; dans lequel la répartition a lieu d'une manière telle que, pour les distributions de probabilités qui résultent des distributions de probabilités mentionnées pour les nombres de pièces pour la somme des temps de production escomptés par ligne de montage, les déviations par rapport à la valeur escomptée respective de ces distributions de probabilités résultantes, sont limitées par une valeur seuil maximale qui peut être prédéfinie ; dans lequel on détermine une déviation par rapport à la somme des temps de production escomptés d'une ligne de montage sous la forme d'une variance de la somme en question, que l'on peut déterminer, par ligne de montage, par l'intermédiaire de la somme, qui recouvre tous les types d'assemblages de circuits qui sont répartis sur la ligne de montage, à partir du produit de la déviation quadratique du nombre de pièces escompté d'un type d'assemblage de circuits au sein d'un espace de temps et à partir des valeurs correspondantes des distributions de probabilités qui en résultent, et multiplié par le temps de cycle au carré ; et dans lequel on calcule la répartition des assemblages de circuits (LP1 - LP6) sur les lignes de montage (BL1 - BL1) dans le cadre des spécifications indiquées au moyen de la programmation linéaire en nombres entiers ; dans lequel on minimise une somme pondérée constituée par la variance de composant et par la déviation maximale par rapport à la somme des temps de production que l'on escompte.

2. Procédé assisté par ordinateur selon la revendication précédente, dans lequel on minimise la somme des temps de production escomptés des lignes de montage (BL1 - BL1) au moyen de la programmation linéaire en nombres entiers.

3. Procédé assisté par ordinateur selon l'une quelconque des revendications précédentes, **caractérisé en ce que** les déviations mentionnées par rapport aux valeurs attendues des distributions de probabilités résultantes prennent des valeurs semblables ou égales.

4. Procédé assisté par ordinateur selon l'une quelconque des revendications précédentes, dans lequel des quantités d'assemblages de circuits (LP1 - LP6) précisées par l'exploitant sont réparties sur la même ligne de montage (BL1 - BL2).

5. Procédé assisté par ordinateur selon l'une quelconque des revendications précédentes, dans lequel, à titre de données d'entrée pour la programmation linéaire en nombres entiers, on utilise les données suivantes, qui décrivent l'infrastructure, à savoir :

   - le nombre des lignes de montage (BL1 - BL2) ;
   - le nombre des assemblages de circuits (LP1 - LP6) ;
   - le nombre des types d'assemblages de circuits ;
   - le nombre des types de composants ;
   - la quantité des types de composants à répartir par type d'assemblage de circuits ;
   - la limite de temps de production par ligne de montage respective (BL1 - BL2) ;
   - les distributions de probabilités pour les nombres de pièces escomptés des types d'assemblages de circuits.

6. Procédé assisté par ordinateur selon l'une quelconque des revendications précédentes, dans lequel on calcule le temps de production global pour un type respectif d'assemblage de circuits sur une ligne de montage respective (BL1 - BL2) à partir :

   - du nombre des demandes escomptées ;
   - des dimensions du lot ;
   - des temps de réaménagement ;
   - des temps de production individuels par assemblage de circuits (LP1 - LP6) et par ligne de montage (BL1 - BL1) ;
   - des temps de cycles minimaux des lignes de montage (BL1 - BL2) ;
   - du degré d'exploitation des lignes de montage (BL1 - BL2).

7. Procédé assisté par ordinateur selon l'une quelconque des revendications précédentes, dans lequel on règle la programmation linéaire au moyen d'un programme linéaire en nombres entiers, que l'on solutionne en passant par les étapes suivantes dans lesquelles :

   a) on détermine une première solution en vigueur qui représente une répartition d'assemblages de circuits sur des lignes de production ;
   b) on répartit une quantité sélectionnée d'assemblages de circuits (LP1 - LP6) sur les lignes de montage (BL1 - BL2), en se basant sur une solution en vigueur ;
   c) on calcule les nouvelles répartitions au moyen d'un programme d'optimisation ou d'un résolveur standard en se basant sur une programmation linéaire en nombres entiers.

8.  Procédé assisté par ordinateur selon l'une quelconque des revendications précédentes, dans lequel on franchit les étapes d'une manière itérative et une interruption de programme a lieu lorsqu'on a atteint une qualité de résolution ou une limite de temps qui a été déterminée à l'avance.

9.  Dispositif destiné à la répartition d'assemblages de circuits (LP1 - LP6) sur des lignes de montage (BL1 - BL2) à des fins de montage des assemblages de circuits (LP1 - LP6) avec des composants (B1 - B6), qui présente :

    - une unité qui est destinée à déterminer un temps de production escompté pour chaque type d'assemblage de circuits parmi les assemblages de circuits (LP1 - LP6) qui doivent faire l'objet d'un montage et pour chaque ligne de montage (BL1 - BL2) en prenant en compte le temps de cycle respectif du type d'assemblage de circuits sur la ligne de montage (BL1 - BL2) et le nombre de pièces à produire escompté par type d'assemblage de circuits ; dans lequel on peut obtenir le nombre de pièces à produire de manière effective en se référant à une distribution de probabilités qui peut être déterminée à l'avance ; dans lequel, pour la quantité des assemblages de circuits (LP1 - LP6) répartis sur une ligne de montage (BL1 - BL2), la somme de ces temps de production globaux escomptés ne peut pas dépasser vers le haut la charge temporelle maximale de la ligne de montage respective (BL1 - BL2) ; dans lequel les répartitions possibles des assemblages de circuits (LP1 - LP6) sur les lignes de montage (BL1 - BL2) peuvent être limitées par l'infrastructure en présence et/ou par des spécifications précisées par l'exploitant ; et dans lequel la variance de composant peut être déterminée sous la forme de la somme des nombres des types de composants requis sur les lignes de montage (BL1 - BL2) pour atteindre une variance de composant minimale dans le cadre de charges temporelles maximales prédéfinies par ligne de montage (BL1 -BL2) ; et
    - une unité destinée à calculer la répartition des assemblages de circuits (LP1 - LP6) sur les lignes de montage (BL1 - BL2) dans le cadre des spécifications fournies au moyen de la programmation linéaire en nombres entiers ; dans lequel le calcul de la répartition a lieu d'une manière telle que, pour les distributions de probabilités qui résultent des distributions de probabilités mentionnées pour les nombres de pièces pour la somme des temps de production escomptés par ligne de montage, les déviations par rapport à la valeur escomptée respective de ces distributions de probabilités qui en résultent, sont limitées par une valeur seuil maximale qui peut être prédéfinie ; dans lequel on détermine une déviation par rapport à la somme des temps de production escomptés d'une ligne de montage sous la forme d'une variance de la somme en question que l'on peut déterminer par ligne de montage par l'intermédiaire de la somme, qui recouvre tous les types d'assemblages de circuits qui sont distribués sur la ligne de montage, à partir du produit de la déviation quadratique du nombre de pièces escompté d'un type d'assemblage de circuits au sein d'un espace de temps et à partir des valeurs correspondantes des distributions de probabilités qui en résultent, et multiplié par le temps de cycle au carré ; et dans lequel on minimise une somme pondérée constituée par la variance de composant et par la déviation maximale par rapport à la somme des temps de production escomptés.

10. Dispositif selon la revendication précédente, **caractérisé en ce que** les déviations mentionnées par rapport aux valeurs attendues des distributions de probabilités résultantes peuvent prendre des valeurs semblables ou égales.

11. Dispositif selon l'une quelconque des revendications de dispositif précédentes, dans lequel des quantités d'assemblages de circuits (LP1 - LP6) précisées par l'exploitant peuvent être réparties sur la même ligne de montage (BL1 - BL2).

12. Programme informatique qui comprend des moyens pour la mise en œuvre du procédé selon l'une quelconque des revendications de procédé précédentes, lorsque le programme informatique est exécuté sur un dispositif conformément à l'une quelconque des revendications de dispositif précédentes.

13. Support lisible par ordinateur, qui comprend des instructions qui, lorsqu'elles sont exécutées sur le dispositif selon l'une quelconque des revendications de dispositif précédentes, amènent le dispositif à exécuter le procédé selon l'une quelconque des revendications de procédé précédentes .

FIG 1

# FIG 2

# FIG 3

**IN DER BESCHREIBUNG AUFGEFÜHRTE DOKUMENTE**

**In der Beschreibung aufgeführte Patentdokumente**

- DE 102008020167 A1
- EP 284528 A1
- US 6829514 B2
- DE 19834620 A1
- DE 102011076565 B4
- WO 2014005741 A1
- WO 2014005743 A1
- WO 2014005744 A1